(19) Europäisches Patentamt
European Patent Office
Office européen des brevets

(11) **EP 1 835 294 B1**

(12) **FASCICULE DE BREVET EUROPÉEN**

(45) Date de publication et mention
de la délivrance du brevet:
**03.03.2010 Bulletin 2010/09**

(51) Int Cl.:
***G01P 15/125*** *(2006.01)*

(21) Numéro de dépôt: **07103819.4**

(22) Date de dépôt: **09.03.2007**

(54) **Accelerometre triaxal a membrane**

Dreiachsiger Beschleunigungsmesser mit Membran

Triaxial accelerometer with membrane

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **14.03.2006 FR 0602216**

(43) Date de publication de la demande:
**19.09.2007 Bulletin 2007/38**

(73) Titulaire: **COMMISSARIAT A L'ENERGIE ATOMIQUE**
**75015 Paris (FR)**

(72) Inventeurs:
• **Robert, Philippe**
**38000, GRENOBLE (FR)**
• **Hentz, Sébastien**
**38000, GRENOBLE (FR)**

(74) Mandataire: **Guérin, Michel**
**Marks & Clerk France**
**Conseils en Propriété Industrielle**
**Immeuble " Visium "**
**22, avenue Aristide Briand**
**94117 Arcueil Cedex (FR)**

(56) Documents cités:
**EP-A1- 0 744 603        WO-A-03/083492**
**JP-A- 2004 150 993**

• **LEMKIN M A ET AL: "A 3-axis force balanced accelerometer using a single proof-mass" 1997 INTERNATIONAL CONFERENCE ON SOLID-STATE SENSORS AND ACTUATORS. DIGEST OF TECHNICAL PAPERS. TRANSDUCERS 97. CHICAGO, IL, JUNE 16 - 19, 1997. SESSIONS 3A1 - 4D3. PAPERS NO. 3A1.01 - 4D3.14P, INTERNATIONAL CONFERENCE ON SOLID-STATE SENSORS AND ACTU, vol. VOL. 2, 16 juin 1997 (1997-06-16), pages 1185-1188, XP010240691 ISBN: 0-7803-3829-4**

EP 1 835 294 B1

## Description

L'invention concerne les capteurs inertiels micro-usinés, c'est-à-dire réalisés par des technologies très proches de celles qui sont utilisées dans la microélectronique. Elle concerne plus particulièrement les accéléromètres.

Le micro-usinage permet de faire des accéléromètres de taille très réduite et à coût relativement faible puisqu'on peut usiner simultanément un grand nombre d'accéléromètres sur une même tranche de support avant de les diviser en puces individuelles.

Cependant, même avec ce type de technologie, il reste souhaitable de réduire encore les dimensions et les coûts. En effet, il y a de plus en plus d'applications dans le domaine grand public (automobile, téléphonie mobile, etc.) et dans le domaine professionnel (aéronautique, robotique industrielle, etc.) où le coût, d'une part, et l'encombrement, d'autre part, sont des enjeux majeurs, le coût étant d'ailleurs en général inversement proportionnel à la taille pour une technologie donnée.

En particulier, dans les applications où on a besoin de détecter des accélérations dans les trois dimensions de l'espace, on a d'abord utilisé trois accéléromètres simples, orientés chacun dans une direction différente pour mesurer les accélérations dans chacune de ces directions. Cette solution est encombrante et coûteuse puisqu'elle exige trois composants micro-usinés et un montage de ces trois composants dans des orientations différentes mais bien précises sur une plateforme commune.

On a donc cherché à réaliser des accéléromètres triaxiaux utilisant une masse sismique commune micro-usinée, pourvue de moyens de détection des déplacements de la masse selon trois axes indépendants.

On a proposé notamment des accéléromètres triaxiaux dans lesquels la masse sismique est relativement épaisse (100 à 200 micromètres par exemple) parce qu'elle est taillée dans toute l'épaisseur d'un substrat de silicium. La détection est capacitive ou piézoélectrique ou piézorésistive. Ce type de réalisation implique une fabrication par collage de plusieurs tranches de silicium (ou d'autres matériaux) : en général trois tranches ; la technologie est assez coûteuse car il faut prévoir des gravures très profondes pour définir la masse sismique, et ces gravures profondes nécessitent alors des surfaces importantes, donc un encombrement correspondant. Par ailleurs, ces capteurs sont réalisés souvent en utilisant des techniques de report de substrats, ce qui pose des problèmes d'imprécision dimensionnelle dans la direction perpendiculaire au substrat, la réponse de ces capteurs aux accélérations, c'est-à-dire l'amplitude du signal de sortie en fonction de l'accélération, peut alors être imprécise, peu linéaire. De plus, les axes de sensibilité ne sont pas très indépendants, c'est-à-dire qu'une accélération selon un axe unique induit des signaux parasites sur les sorties correspondant aux autres axes. Il faut donc prévoir des systèmes de compensation, ce qui est aussi un inconvénient.

Pour éviter ces inconvénients, on a proposé également des accéléromètres triaxiaux dont la masse sismique est réalisée non pas dans l'épaisseur globale d'un substrat de silicium mais dans l'épaisseur beaucoup plus faible d'une couche suspendue au-dessus d'un substrat. La détection est capacitive, avec des peignes interdigités pour les axes horizontaux, et avec des capacités planes (entre la masse sismique et le substrat situé au-dessous de la masse). Si on doit asservir la position de la masse à une position centrale de repos, comme c'est souvent souhaitable pour améliorer les performances, on peut le faire selon les axes horizontaux, en utilisant des peignes interdigités affectés à cet asservissement, mais on ne peut pas le faire dans les deux directions (haut et bas) de l'axe vertical sans compliquer considérablement la technologie.

L'article "A 3-Axis Force Balanced Accelerometer Using a single Proof-Mass", de Mark A. Lemkin, Bernhard E. Boser, David Auslander, Jim H. Smith, publié dans les proceedings IEEE Transducers '97, suite à la conférence de 1997 "International Conference on Solid-State Sensors and Actuators", décrit un tel accéléromètre à masse sismique usinée en technologie de surface.

Pour limiter les inconvénients des structures d'accéléromètres triaxiaux de l'art antérieur, la présente invention propose une structure d'accéléromètre caractérisée en ce qu'elle comporte un substrat, une membrane élastiquement déformable en couche mince suspendue au-dessus du substrat et solidaire du substrat à sa périphérie, une masse sismique suspendue au-dessus de la membrane et reliée à celle-ci par un pion central, et des peignes interdigités capacitifs répartis autour de la masse, ayant des armatures mobiles solidaires de la masse et des armatures fixes solidaires du substrat.

La masse étant suspendue au-dessus de la membrane et reliée à celle-ci par un plot ponctuel, toute la périphérie de la membrane est disponible pour y répartir des peignes interdigités. Des peignes capacitifs pour la mesure de déplacements peuvent être prévus, mais éventuellement aussi des peignes capacitifs pour l'asservissement de la masse vers une position centrale de repos.

De préférence, les armatures fixes de certains des peignes capacitifs ont une hauteur, mesurée dans le sens perpendiculaire à la membrane, plus faible que la hauteur des armatures mobiles de ces peignes, et les armatures mobiles de certains peignes ont une hauteur dans le sens perpendiculaire à la membrane plus faible que la hauteur des armatures fixes de ces peignes ; de cette manière, la différence des capacités de deux peignes ainsi rendus dissymétriques va varier dans des sens opposés selon que la masse se déplace verticalement (perpendiculairement à la membrane) dans un sens ou dans l'autre.

De préférence, sur chaque côté de la membrane, on prévoit deux peignes, ayant l'un des armatures fixes plus hautes que les armatures mobiles et l'autre des armatures mobiles plus hautes que les armatures fixes, et les deux peignes en vis-à-vis sur deux côtés opposés ont également l'un des armatures fixes plus hautes que les armatures mobiles et l'autre des armatures mobiles plus hautes que les armatures fixes.

De préférence encore, les espacements entre armatures des deux peignes d'un même côté varient dans des sens opposés pour un même sens de déplacement horizontal de la masse sismique.

On prévoit aussi de préférence que deux peignes en vis-à-vis sur deux côtés opposés ont des espacements entre armatures qui varient dans le même sens pour un même déplacement de la masse sismique parallèlement à ces côtés.

Enfin, on prévoit de préférence que la disposition de l'ensemble du capteur est symétrique pour que les capacités au repos (en l'absence d'accélérations) de tous les peignes interdigités soient identiques.

En l'absence d'asservissement de la position de la masse sismique, la mesure d'accélération selon les trois axes se fait par une mesure (directe ou indirecte) des capacités ou variations de capacités des peignes interdigités et des combinaisons linéaires des différentes mesures pour extraire les composantes de variations dues aux différentes composantes de l'accélération.

Typiquement, la mesure de l'accélération selon un axe horizontal parallèle à deux côtés de la masse sismique se fait par une combinaison linéaire des valeurs de capacités de quatre peignes situés le long de ces côtés. La mesure de l'accélération selon un axe vertical perpendiculaire à la membrane se fait par une combinaison linéaire des valeurs de capacités de huit peignes, cette combinaison étant la différence entre la somme des capacités de quatre peignes situés chacun sur un côté respectif de la masse sismique et ayant des armatures fixes plus basses que les armatures mobiles, et la somme des capacités de quatre autres peignes situés également chacun sur un côté respectif de la masse sismique et ayant des armatures mobiles plus basses que les armatures fixes.

Un asservissement est également possible. Des peignes supplémentaires sur les quatre côtés peuvent être prévus pour réaliser un asservissement par force électrostatique afin de rappeler la masse vers sa position de repos en présence d'une accélération qui tend à l'écarter de cette position de repos. Dans ce cas, la mesure d'accélération se fait non pas par mesure directe ou indirecte des capacités des peignes interdigités mais par mesure des tensions ou courants d'asservissements nécessaires pour maintenir à leurs valeurs de repos les capacités des peignes. Il est possible également d'utiliser les mêmes peignes pour la mesure et l'asservissement grâce par exemple à un multiplexage temporel à deux phases alternées : phase d'application de force électrostatique alternée avec une phase de mesure de capacité.

D'autres caractéristiques et avantages de l'invention apparaîtront à la lecture de la description détaillée qui suit et qui est faite en référence aux dessins annexés dans lesquels :

- la figure 1 représente une vue de dessus schématique de l'accéléromètre selon l'invention ;
- la figure 2 représente une vue en coupe selon la ligne brisée II-II de la figure 1 ;
- la figure 3 représente une vue en coupe montrant le déplacement de la masse sismique en présence d'une accélération vers le bas selon l'axe vertical Oz perpendiculaire au plan de la figure 1 ;
- la figure 4 représente le déplacement de la masse sismique en présence d'une accélération vers le haut selon l'axe vertical Oz ;
- la figure 5 représente le déplacement de la masse sismique en présence d'une accélération horizontale vers la gauche, selon l'axe Ox ;
- les figures 6 à 14 représentent les différentes étapes d'un exemple de procédé de fabrication du capteur selon l'invention;
- les figures 15 à 18 représentent les étapes d'un autre exemple de procédé de fabrication.

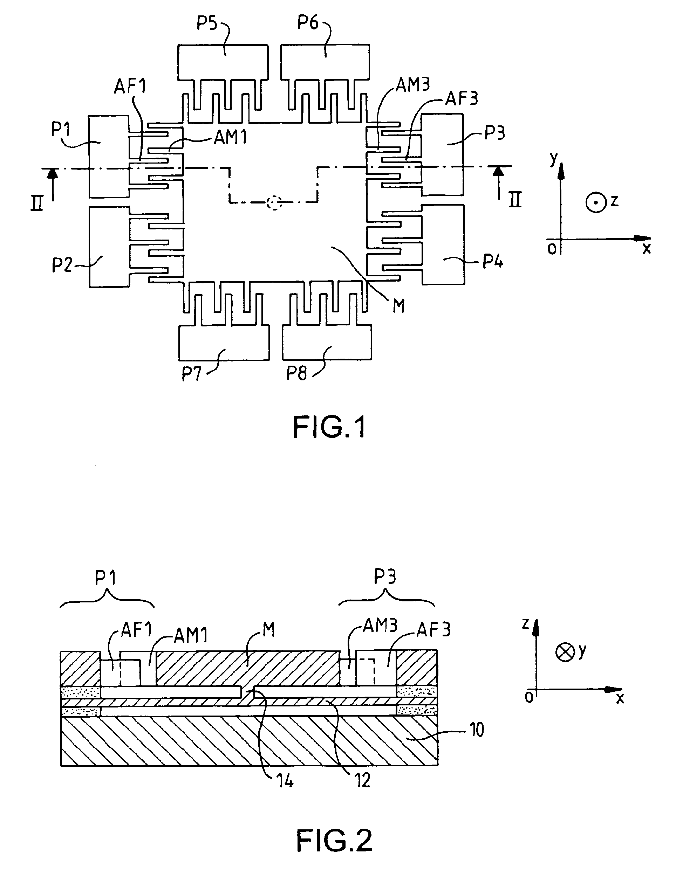

Sur la vue de dessus de la figure 1, on voit une masse sismique mobile M, de forme par exemple rectangulaire ou carrée, voire même circulaire, pourvue sur chacun de ses côtés de peignes capacitifs interdigités. Les peignes interdigités sont classiquement utilisés pour la mesure des déplacements de la masse sismique dans les accéléromètres micro-usinés. Ce sont des capacités variables ayant des armatures mobiles qui sont des doigts de peigne solidaires de la masse sismique et des armatures fixes qui sont des doigts de peigne solidaires de portions fixes d'un substrat de l'accéléromètre. Il y a au moins un peigne interdigité sur chaque côté, mais de préférence deux peignes par côté. Si l'accéléromètre est de type asservi il peut y avoir des peignes supplémentaires ayant une fonction de moteur électrostatique, mais ce n'est pas obligatoire, les mêmes peignes pouvant servir à la mesure et à l'asservissement.

La capacité de chaque peigne au repos est définie par le nombre d'armatures en parallèle, par la surface des armatures individuelles en regard l'une de l'autre, et par l'espacement au repos entre les armatures. Lors des déplacements de la masse sismique, l'espacement peut varier, mais la surface en regard peut varier aussi, et ces deux types de variation contribuent aux variations globales de capacité qui seront mesurées. Seules trois couples d'armatures sont représentées pour chaque peigne sur la figure 1, mais dans la pratique le nombre d'armatures est très supérieur pour obtenir une capacité suffisante.

A titre d'exemple préférentiel, on a représenté sur la figure 1 une structure à deux peignes par côté de la masse : peignes P1, P2 sur un premier côté parallèle à un premier axe de mesure Oy ; peignes P3, P4 en vis-à-vis des peignes P1 et P2 sur un côté opposé ; peignes P5, P6 sur un côté parallèle à un deuxième axe de mesure Ox ; peignes P7, P8 symétriques des peignes P5, P6 sur le côté opposé. Les deux peignes d'un même côté, par exemple P1 et P2, sont agencés en symétrie inverse pour qu'un déplacement de la masse dans un sens fasse augmenter l'espacement des armatures de l'un des peignes (P1 par exemple) et fasse simultanément diminuer l'espacement des armatures de l'autre peigne (P2), de manière à pouvoir plus facilement travailler en différentiel. On notera qu'au repos les armatures des doigts mobiles ne sont pas au centre de l'intervalle entre doigts fixes et réciproquement, et c'est ce décentrage qui est inversé pour les deux peignes situés sur un même côté. Pour des peignes situés en vis-à-vis l'un de l'autre sur deux côtés opposés, comme par exemple P1 et P3, la disposition des armatures est de préférence telle que les espacements entre armatures varient dans le même sens pour un déplacement de la masse dans la direction de ces côtés (Oy). Par conséquent, dans ce cas, deux peignes diagonalement opposés, tels que P1 et P4 ou P2 et P3 ont des capacités qui varient en sens inverse l'une de l'autre pour un déplacement dans la direction des côtés qui les portent.

On a donc la disposition préférée suivante:

- P1 et P3 : même variation de capacité pour un déplacement dans la direction Oy; P2 et P4 : variation opposée ;
- P5 et P7 : même variation de capacité pour un déplacement dans la direction Ox; P6 et P8 : variation opposée.

La figure 2 représente une vue en coupe verticale de l'accéléromètre, supposé au repos, usiné dans un substrat 10 qui est de préférence en silicium. La masse sismique M est supportée uniquement en son centre par une fine membrane 12 élastiquement déformable dont la périphérie est solidaire du substrat 10. Un pion central 14 de petites dimensions relie le centre de la masse sismique au centre de la membrane. Le pion 14 forme une attache ponctuelle de la masse au centre de la membrane. La masse sismique déforme la membrane lorsqu'elle tend à se déplacer sous l'effet d'une accélération, la déformation et le déplacement de la masse étant limitées par la force de rappel exercée par la membrane. Celle-ci tend à rappeler la masse en position de repos en l'absence d'accélération.

La membrane est suspendue au-dessus du substrat 10 avec un intervalle vide suffisant pour permettre un mouvement vertical de la membrane en présence d'une accélération verticale vers le bas dans la gamme des accélérations que le capteur est destiné à mesurer. De même, un intervalle libre est laissé au-dessus de la membrane pour autoriser un déplacement de la membrane en présence d'une accélération vers le haut. Ces intervalles peuvent être très faibles dans le cas où l'accéléromètre fonctionne avec asservissement de la position de la masse.

Pour la mesure des accélérations horizontales selon l'axe Oy, on utilise principalement les variations de capacité dues aux peignes P1, P2 et P3, P4. En effet, ces variations de capacité résultent d'une modification d'espacement (ou entrefer) entre les armatures de ces peignes et les capacités sont particulièrement sensibles à ces variations d'espacement (entrefer). Il faut noter cependant que des variations de capacité plus limitées existent aussi sur les peignes des autres côtés lors de ce déplacement selon Oy mais on verra qu'on fait en sorte que ces variations se neutralisent.

Pour la mesure des accélérations verticales, on joue sur le fait qu'a priori le déplacement vertical des armatures mobiles peut modifier la surface d'armature mobile en regard d'une armature fixe. Si les armatures fixes ont exactement la même hauteur que les armatures mobiles et si elles sont exactement en regard de ces dernières au repos, alors un déplacement vertical de la masse mobile va diminuer les surfaces en regard et la diminution de capacité qui en résulte peut être mesurée. Par conséquent on peut observer une variation de toutes les capacités dont les surfaces d'armatures en regard sont modifiées suite à un déplacement vertical. Cependant, cette solution ne permet pas de distinguer une accélération vers le haut d'une accélération vers le bas car la variation de capacité est la même dans les deux cas : c'est une réduction de capacité proportionnelle à la distance de déplacement vertical.

Pour distinguer les accélérations vers le haut des accélérations vers le bas, on prévoit selon l'invention une dissymétrie des armatures fixes et mobiles de la manière suivante : les peignes sont constitués avec des armatures fixes ayant une hauteur différente de la hauteur des armatures mobiles ; pour l'un des peignes c'est l'armature mobile qui est plus haute que l'armature fixe ; pour l'autre c'est le contraire. Sur les figures, le peigne P1 a des armatures fixes AF1 de hauteur plus faible que les armatures mobiles AM1, tandis que le peigne P3 en vis-à-vis sur le côté opposé a des armatures mobiles AM3 de hauteur plus faible que les armatures fixes AF3. Toutes les armatures d'un même peigne sont de préférence identiques et les peignes présentent donc globalement ces différences de hauteur d'armatures.

On notera que cette dissymétrie de hauteur pour la discrimination des accélérations verticales et horizontales constitue en soi une disposition avantageuse indépendamment du mode de support et de liaison (pion central, membrane) de la masse sismique au substrat, dès lors que les peignes interdigités qui entourent la masse servent à la fois à la mesure des accélérations verticales et des accélérations horizontales.

La figure 2 représente l'accéléromètre en l'absence d'accélération.

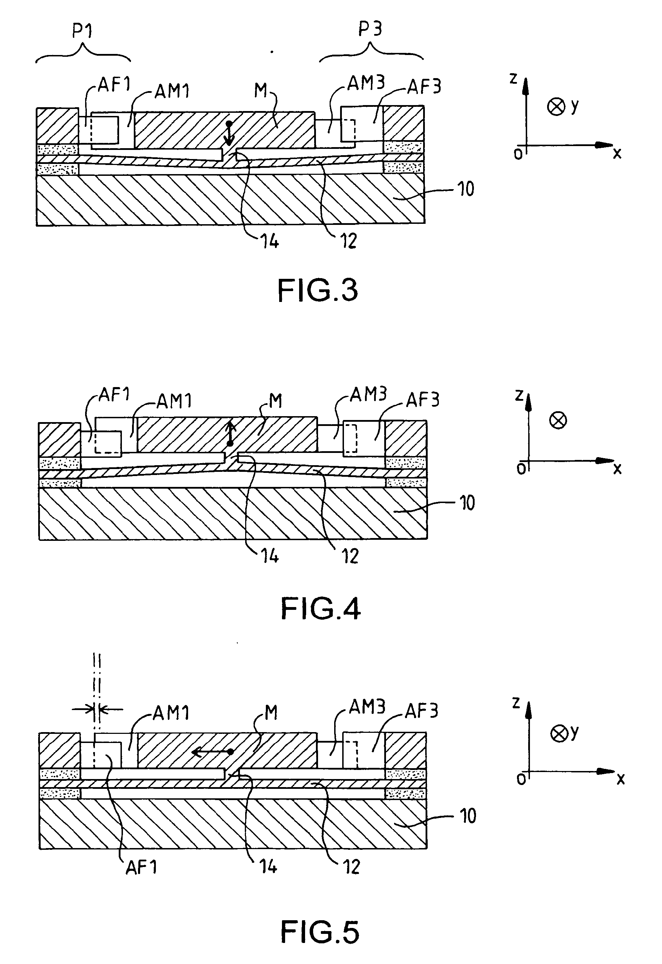

La figure 3 représente la même coupe verticale qu'à la figure 2, en présence d'une accélération verticale vers le bas (en l'absence d'accélération horizontale), montrant avec une exagération d'échelle les positions respectives des armatures AF1 et AM1 d'un côté, AF3 et AM3 de l'autre. La masse sismique se déplace vers le bas, l'armature mobile AM3 du peigne de droite descend au-dessous de l'armature fixe AF3 et les surfaces d'armatures en regard diminuent ; la capacité du peigne P3 diminue. Mais l'armature fixe AF1 de l'autre côté reste complètement en regard de l'armature mobile AM1 qui est plus haute, du fait que la différence de hauteur est au moins égale à la hauteur de déplacement maximum possible de la masse ; la capacité du peigne P1 ne diminue pas.

Inversement, si la masse sismique se déplace vers le haut c'est le contraire, la capacité du peigne P1 diminue, celle du peigne P3 ne diminue pas. On peut donc de cette manière discriminer les accélérations positives et négatives selon l'axe vertical Oz.

La figure 4 représente l'accéléromètre pour une accélération verticale vers le haut.

De préférence, les huit peignes de la structure représentée à la figure 2 sont ainsi dissymétriques deux à deux comme P1 et P3, c'est-à-dire que les armatures fixes d'un peigne (P1, P4, P6, P7) sont plus basses que les armatures mobiles, et inversement les armatures mobiles des peignes situés en vis-à-vis sur le côté opposé (respectivement P3, P2, P8, P5) sont plus basses que les armatures fixes. La disposition est ainsi très symétrique mais d'autres dispositions pourraient également être envisagées, par exemple une disposition dans laquelle seuls quatre peignes, voire même seulement deux, ont des armatures fixes et mobiles de hauteurs différentes pour assurer la discrimination des déplacements verticaux de la masse sismique, les autres ayant des armatures fixes et mobiles de même hauteur.

La figure 5 représente une vue pour une accélération horizontale selon Ox, vers la gauche. La force exercée sur la masse sismique tend à déplacer la masse vers la gauche et tend à engendrer une augmentation des surfaces d'armatures en regard pour le peigne P1 et une diminution des surfaces en regard pour le peigne P3, donc une augmentation de la capacité du peigne P1 et une diminution de celle du peigne P3 ; ces variations sont mentionnées parce qu'elles existent mais ce ne sont pas elles qui sont utilisées, comme on l'expliquera plus loin. Ce qu'on ne peut pas représenter sur la figure 5 c'est le fait que ce déplacement vers la gauche engendre aussi une diminution de la capacité des peignes P5 et P7 par augmentation de l'espacement entre armatures et une augmentation de la capacité des peignes P6 et P8 par diminution des espacements entre armatures. C'est ce deuxième effet qui contribue véritablement à la mesure de l'accélération selon Ox.

On va maintenant expliquer comment on effectue la discrimination des composantes de déplacement (donc d'accélérations) à partir des mesures directes ou indirectes des capacités des différents peignes.

L'exemple sur lequel on se fonde est celui qui a été décrit ci-dessus, dans lequel :

- il y a deux peignes sur chaque côté, huit au total pour la mesure des variations de capacités ; tous les peignes ont, au repos, des surfaces d'armatures en regard identiques;
- les peignes d'un même côté (P1, P2 par exemple) sont symétriques en ce qui concerne l'espacement des armatures fixes et mobiles pour qu'un déplacement de la masse parallèlement à ce côté produise des variations de capacité identiques mais de signe opposé pour les deux peignes ;
- les peignes situés en vis-à-vis sur deux côtés opposés (P1, P3 par exemple) ont une disposition d'espacement entre armatures telle que le déplacement de la masse parallèlement à ces côtés engendre des variations de capacité identiques et de même signe pour les deux peignes ;
- les peignes situés en vis-à-vis sur deux côtés opposés présentent une dissymétrie de hauteurs d'armatures : armatures fixes plus basses que les armatures mobiles pour un peigne, armatures mobiles plus basses que les armatures fixes pour l'autre peigne ;
- les peignes diagonalement opposés (P1, P4 par exemple) ont des hauteurs relatives d'armatures identiques : si P1 a des armatures fixes plus basses que les armatures mobiles, alors P4 aussi ; les peignes P6 et P7 sont supposés identiques aux peignes P1 et P4 ;
- enfin, la hauteur des armatures fixes qui sont plus hautes est égale à la hauteur des armatures mobiles qui sont plus hautes, et de même la hauteur des armatures fixes qui sont plus basses est égale à la hauteur des armatures mobiles qui sont plus basses, afin que les capacités au repos de tous les peignes soient identiques indépendamment du fait que les peignes aient leur armature fixe ou leur armature mobile plus haute que l'autre.

La symétrie est telle que toutes les capacités de peignes sont identiques au repos, et on travaille en relatif pour éliminer autant que possible toutes les dissymétries qui pourraient exister.

On appelle :

- $C_0$ la valeur de la capacité au repos de chacun des peignes;
- Ci (i = 1 à 8) la capacité du peigne Pi présence d'une accélération,
- dCiv la variation de la capacité Ci spécifiquement due à une accélération verticale (donc due à la variation de surfaces d'armatures en regard suite à un déplacement de la masse sismique dans la direction verticale Oz) ;
- dCixe la variation de la capacité Ci due à une modification d'espacement d'armatures (et non de surfaces en regard) dans la direction Ox ; dCixe est nul pour i = 1, 2, 3, 4 et non nul pour i = 5, 6, 7,8;

- dCiye la variation de la capacité Ci due à une modification d'espacement d'armatures (et non de surfaces en regard) dans la direction Oy ; dCiye est nul pour i = 5, 6, 7, 8 et non nul pour i = 1, 2, 3,4;
- dCixs la variation de la capacité Ci due à une modification de surfaces d'armatures en regard (et non d'espacement) suite à un déplacement dans la direction Ox ; dCixs est nul pour i = 5, 6 7, 8 et non nul pour i = 1, 2, 3, 4 ;
- enfin dCiys la variation de capacité due à une modification de surfaces d'armatures en regard (et non d'espacement) suite à un déplacement dans la direction Oy; dCiys est nul pour i = 1, 2, 3, 4 et non nul pour i = 5, 6, 7, 8.

La valeur de n'importe quelle capacité de peigne est théoriquement :

$Ci = C_0 + dCiv + dCixe + dCixs + dCiye + dCiys$, c'est-à-dire qu'elle est la somme de la valeur au repos et de toutes les variations possibles, d'espacement ou de surfaces d'armatures en regard, en tenant compte du fait que certaines de ces composantes peuvent être nulles si un déplacement dans une direction n'a pas d'influence sur la valeur de la capacité.

Enfin, par symétrie,

- les composantes dCiye sont égales et de signe opposé pour deux peignes adjacents placés sur un côté parallèle à Oy, et égales et de même signe pour deux peignes en vis-à-vis sur les deux côtés opposés parallèles à Oy : par exemple dC1ye = -dC2ye = dC3ye ; il en est de même pour les composantes dCixe pour les peignes placés sur les côtés parallèles à Ox : par exemple dC5xe = -dC6xe = dC7xe ;
- les composantes dCixs sont identiques et de même signe pour deux peignes placés sur le même côté, et identiques et de signe contraire pour deux peignes placés sur le côté opposé : par exemple dC1 xs = dC2xs = -dC3xs = -dC4xs ;
- les composantes dCiv sont toutes égales pour les peignes de même nature en ce qui concerne la hauteur des armatures : les composantes dC1 v, dC4v, dC6v, dC7v des peignes qui ont leur armature fixe de hauteur plus faible que leur armature mobile sont toutes égales ; les composantes dC2c, dC3v, dC5v, dC8v des peignes qui ont leur armature fixe de hauteur plus grande que l'armature mobile sont toutes égales; en présence d'une accélération vers le haut, les premières sont non nulles et les secondes sont nulles; en présence d'une accélération vers le bas, c'est le contraire, les premières sont nulles et les secondes sont non nulles.

De toutes ces remarques on tire des combinaisons linéaires de valeurs de capacité qui ne résultent que de l'influence des accélérations dans la direction Ox ou la direction Oy ou la direction Oz, et qui sont insensibles aux accélérations selon les autres axes. Ces combinaisons linéaires sont les suivantes :

$$Cx = (C5+C7)-(C6+C8)$$

En effet,

$$C5 = C_0+dC5v+dC5xe+ dC5xs +dC5ye + dC5ys$$

avec : dC5xs=0 et dC5ye=0,
soit

$$C5 = C_0+dC5v+dC5xe + dC5ys$$

$$C7 = C_0+dC7v+dC7xe+ dC7xs +dC7ye + dC7ys$$

avec : dC7xs=0, dC7ye=0, dC7xe=dC5xe, dC7ys=-dC5ys
soit

$$dC7xs=0, dC7ye=0, dC7xe=dC5xe, dC7ys=-dC5ys$$

et donc C5+C7 = $2C_0$ + dC5v +dC7v + 2dC5xe, les valeurs dC5ys étant compensées par les valeurs dC7ys.

De même,

$$C7 = C_0 + dC7v + dC5xe - dC5ys$$

avec dC8v=dC5v, dC6v=dC7v, dC6xe=-dC5xe
et donc C6+C8 = $2C_0$ + dC5v + dC7v -2dC5xe
d'où il résulte que

Cx = (C5+C7) - (C6+C8) = 4dC5xe ; cette combinaison linéaire Cx ne dépend pas des accélérations selon y et z : elle représente une variation de capacité due exclusivement à un déplacement selon Ox puisque la variation de dCixe est une variation spécifiquement due à un déplacement selon Ox ; en mesurant la valeur de cette combinaison Cx, on peut directement déterminer le déplacement, donc l'accélération subie selon l'axe Ox.

En faisant le même calcul, on montre que la combinaison linéaire

Cy = (C2+C4) - (C1+C3) = 4dC2ye permet de calculer l'accélération selon Oy.

Enfin, une combinaison linéaire impliquant les huit valeurs de capacités C1 à C8 permet de remonter à la valeur du déplacement selon Oz donc à l'accélération selon Oz.

Cette combinaison linéaire est Cz, avec

$$Cz = (C2+C3+C5+C8) - (C4+C1+C6+C7)$$

Chacun de ces termes subit une variation due aux déplacements selon Ox, Oy et Oz :

a). déplacement selon Oz :

1. les quatre premiers termes C2, C3, C5, C8 sont les capacités des peignes dont les armatures mobiles sont plus basses que les armatures fixes; elles ne varient pas lors d'un déplacement de la masse sismique vers le haut;
2. les quatre autres capacités diminuent lors d'une accélération vers le haut; la variation globale de Cz est donc positive lors d'une accélération vers le haut;
3. pour une accélération vers le bas, c'est l'inverse : la variation de Cz est globalement négative parce que les quatre premiers termes diminuent tandis que les quatre seconds termes ne varient pas.

b). déplacement selon Ox :

1. les variations de capacité de C2 et C3 se compensent en ce qui concerne la variation due à la variation de surfaces en regard selon Ox ; de même pour C1 et C4 ; les variations de surface en regard pour un déplacement selon Ox sont nulles pour C5, C6, C7 et C8 ;
2. les variations dues à l'espacement des armatures ne concernent que C5, C6, C7, C8 ; elles sont nulles mais elles se compensent pour C6 et C7 d'une part, pour C5 et C8 d'autre part.

c). déplacement selon Oy :

1. les variations dues aux modifications de surface en regard sont nulles pour C1, C2, C3, C4 ; elles se compensent pour C5 et C8, ainsi que pour C6 et C7.
2. les variations dues aux modifications d'espacement sont nulles pour C5 à C8; elles sont non nulles mais se compensent pour C2 et C3 d'une part, C1 et C4 d'autre part.

On trouve alors :

$$Cz = 4Cd2v - 4Cd1v$$

Si l'accélération est vers le haut, le terme Cd2v est nul, la variation de capacité C1 est négative (la capacité diminue puisque les surfaces en regard diminuent), et le terme Cz est positif.

Si l'accélération est vers le bas, le terme Cd1 v est nul, la variation de capacité C2 est négative (les surfaces en regard diminuent) et le terme Cz est négatif.

Par cette combinaison linéaire Cz, on obtient donc l'amplitude d'une variation de capacité due exclusivement à un déplacement vertical, donc une valeur de déplacement vertical et d'accélération verticale, avec son signe.

La disposition qui a été décrite est la plus symétrique et donc avantageuse, mais on comprendra qu'on peut trouver d'autres dispositions (et donc d'autres combinaisons linéaires) moins symétriques mais fonctionnant également et permettant d'établir des combinaisons linéaires capables d'isoler les variations de capacité dues à chacune des composantes de l'accélération.

L'accéléromètre comprend, outre les éléments mécaniques qui ont été décrits, les moyens de mesure de capacités et d'addition/soustraction de capacités qui permettent l'établissement des combinaisons linéaires ci-dessus.

Conformément à un principe général connu, on peut effectuer la mesure d'accélération de manière non asservie ou de manière asservie. Si c'est de manière non asservie on se contente de mesurer les capacités, de calculer les combinaisons linéaires, et d'en déduire les déplacements de la masse sous l'effet des différentes composantes de l'accélération. Ces déplacements sont limités par la force de rappel exercée par la membrane 12 qui supporte la masse sismique M, ce qui établit un lien entre le déplacement et la force de rappel, donc un lien entre le déplacement et l'accélération et donc un lien entre une variation de capacité Cx, Cy ou Cz et l'accélération. Si le capteur fonctionne de manière asservie, la mesure est différente : on prévoit un moteur électrostatique pour appliquer à la masse sismique une force qui tend à la maintenir à sa position de repos si la mesure de capacités montre qu'elle s'en écarte, et on mesure les courants ou tensions qu'il faut appliquer au moteur pour maintenir la masse à sa position de repos malgré l'accélération qu'elle subit.

Le plus simple est d'utiliser, comme moteurs, des peignes interdigités semblables aux peignes de mesure décrits ci-dessus, et d'appliquer à ces peignes des tensions qui génèrent les forces électrostatiques tendant à ramener la masse à sa position de repos. Il y a alors quatre peignes sur chaque côté en plus des peignes de mesure. Cependant, comme cela est connu, on peut aussi utiliser les mêmes peignes pour faire la mesure de capacité et pour servir de moteurs électrostatiques, en effectuant par exemple un multiplexage temporel pour alterner mesure et actionnement, ou un empilement de tensions.

Que ce soient les mêmes peignes ou non, les peignes de rappel reçoivent des tensions dont la combinaison est propre à exercer les forces de rappel appropriées selon toutes les composantes. S'ils sont constitués comme les peignes de mesure P1 à P8, on peut appliquer aux peignes de rappel respectifs des tensions V1 à V8 qui répondront aux critères suivants :

- la différence entre les tensions d'asservissement (par exemple V5-V6) appliquées à deux peignes (par exemple P5, P6) dont les espacements varient en sens contraire dans la direction Ox est d'autant plus grande que la combinaison linéaire Cx est plus grande ;
- la différence des tensions d'asservissement (par exemple V2-V1) appliquées à deux peignes (P1, P2) dont les espacements varient en sens contraire dans la direction Oy est d'autant plus grande que la combinaison linéaire Cy est plus grande ;
- les tensions (V1, V4, V6, V7) appliquées aux peignes dont les armatures fixes sont plus basses que les armatures mobiles sont d'autant plus élevées, par rapport aux tensions (V2, V3, V5, V8) appliquées aux autres peignes, que Cz est élevé, lorsque Cz est positif (accélération vers le haut) ;
- les tensions (V2, V3, V5, V8) appliquées aux peignes dont les armatures mobiles sont plus basses que les armatures fixes sont d'autant plus élevées, par rapport aux tensions (V1, V4, V6, V7) appliquées aux autres peignes, que la valeur absolue de Cz est élevée, lorsque Cz est négatif (accélération vers le bas).

Fabrication de l'accéléromètre :

Pour réaliser l'accéléromètre selon l'invention on peut utiliser plusieurs procédés de fabrication dont des exemples sont donnés ci-après.

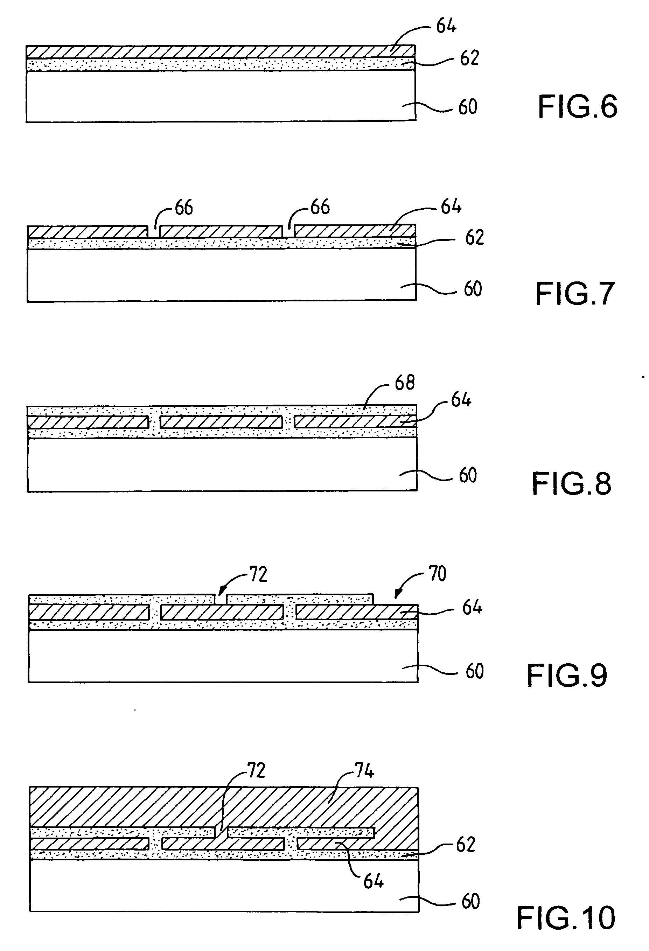

Dans un premier exemple (figure 6), on part d'un substrat de silicium qui est de préférence un substrat de type SOI (silicium sur isolant) composé d'une plaque de silicium 60 ayant à sa partie supérieure une fine couche d'oxyde de silicium enterrée 62 de quelques micromètres d'épaisseur au maximum (par exemple 1 micromètre), elle-même recouverte d'une couche épitaxiale de silicium 64 de quelques micromètres d'épaisseur au maximum (par exemple 2 micromètres) qui formera la membrane de support de la masse sismique.

On ouvre dans la couche épitaxiale de silicium 64 des ouvertures ponctuelles 66 réparties dans toute la zone qui définira la membrane ; ces ouvertures serviront ultérieurement à attaquer la couche sous-jacente d'oxyde de silicium 62 (figure 7).

On dépose une couche d'oxyde de silicium 68 de quelques micromètres (par exemple 5 micromètres), qui recouvre toute la surface du substrat et vient combler les ouvertures 66 (figure 8).

On grave localement cette couche pour éliminer l'oxyde dans au moins une zone 70 servant à la liaison électrique entre la membrane (et ultérieurement la masse sismique) et l'extérieur, afin de pouvoir porter la masse sismique à un potentiel déterminé (la masse par exemple) ; au cours de cette gravure, on ouvre aussi une ouverture ponctuelle 72 au centre de la zone réservée à la membrane, pour définir ce qui sera le point d'attache de la masse sismique avec la membrane (figure 9).

On dépose par épitaxie une couche de silicium monocristallin 74 qui vient en contact direct avec les zones de liaison électrique 70 et qui vient aussi se solidariser avec la couche épitaxiale 64 à travers l'ouverture ponctuelle 72. Le silicium qui remplit l'ouverture 72 constituera le pion central 14 mentionné à propos de la figure 2. L'épaisseur de l'épitaxie formée à ce stade est par exemple d'environ 25 micromètres. Cette couche de silicium constituera à la fois la masse sismique et les peignes interdigités, aussi bien pour les armatures mobiles que pour les armatures fixes. Le silicium est suffisamment dopé pour être conducteur et pour pouvoir servir directement d'armatures de capacité des peignes interdigités. On notera que le silicium croît de manière monocristalline au moins au niveau des contacts avec le silicium monocristallin sous-jacent de la couche 64, c'est-à-dire à l'endroit des ouvertures 70 et 72, mais il peut rester polycristallin dans les zones éloignées de ces points de contact (figure 10).

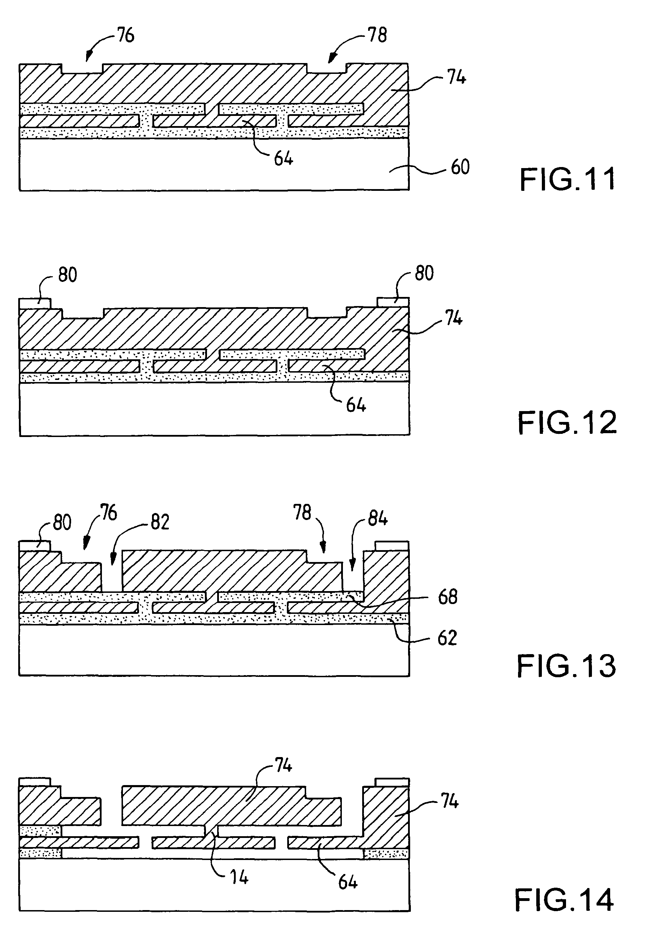

On amincit localement la couche de silicium 74 par gravure locale partielle dans des zones qui définissent les armatures de peignes de plus faible hauteur, que ce soient des armatures fixes (zones 76) ou mobiles (zones 78) ; (figure 11). Sur les figures on a simplifié le dessin en ne représentant qu'une armature fixe à gauche et une armature mobile à droite, sans montrer l'interdigitation qui ne serait pas facile à représenter sur une vue en coupe verticale ; les zones 76 et 78 sont cependant gravées avec précision pour réduire la hauteur des armatures fixes (ou mobiles) à l'intérieur d'un peigne sans réduire la hauteur des armatures en regard à l'intérieur du même peigne.

On notera que les hauteurs différentes d'armatures peuvent être définies non pas en creux au niveau des armatures à abaisser mais en dépassement au niveau d'armatures à surélever pour leur donner une plus grande hauteur. Dans ce cas, au lieu de graver les zones 76 et 78, on grave tout le reste de la surface en laissant les zones 76 et 78 dépasser.

On dépose ensuite et on grave une couche métallique 80 pour prendre des contacts électriques avec les différentes armatures de peignes. Les armatures mobiles seront toutes au même potentiel, étant solidaires de la masse sismique qui est globalement conductrice, et le contact de droite restera relié à la membrane donc à la masse sismique pour porter cette dernière au potentiel désiré. Inversement, les peignes fixes doivent pouvoir être séparément connectés à des organes de mesure de potentiel ou d'application de potentiel et un contact séparé par peigne est prévu (figure 12).

On grave toute l'épaisseur du silicium de la couche 74 pour définir d'une part la masse sismique M, d'autre part chacun des peignes fixes isolé des autres peignes et pour définir chacune des armatures fixe ou mobile de chacun de ces peignes. La figure 13 ne représente que symboliquement deux ouvertures 82 et 84 de séparation entre la masse sismique, au centre, et les peignes, à droite et à gauche mais dans la réalité cette opération de gravure définit chaque intervalle entre deux armatures fixe et mobile en regard. La gravure du silicium s'arrête sur la couche isolante 68.

Par les ouvertures ainsi gravées dans la couche de silicium, on attaque par gravure anisotrope l'oxyde de silicium des couches 68 puis 62. Pour cette dernière, la dissolution de l'oxyde, par exemple avec du fluorure d'hydrogène, se fait à travers les ouvertures 66 qui avaient été faites à l'étape de la figure 7. La gravure de l'oxyde laisse subsister de l'oxyde qui solidarise les peignes et le substrat de départ 60 (figure 14). On aboutit à la structure d'accéléromètre définie aux figures 1 et 2 avec la couche de silicium 74 pour servir de masse sismique suspendue et d'armatures mobiles et fixes de peignes, et la couche de silicium 64 pour servir de membrane suspendue, un pion central de silicium 14 solidarisant la membrane et la masse au centre de cette dernière.

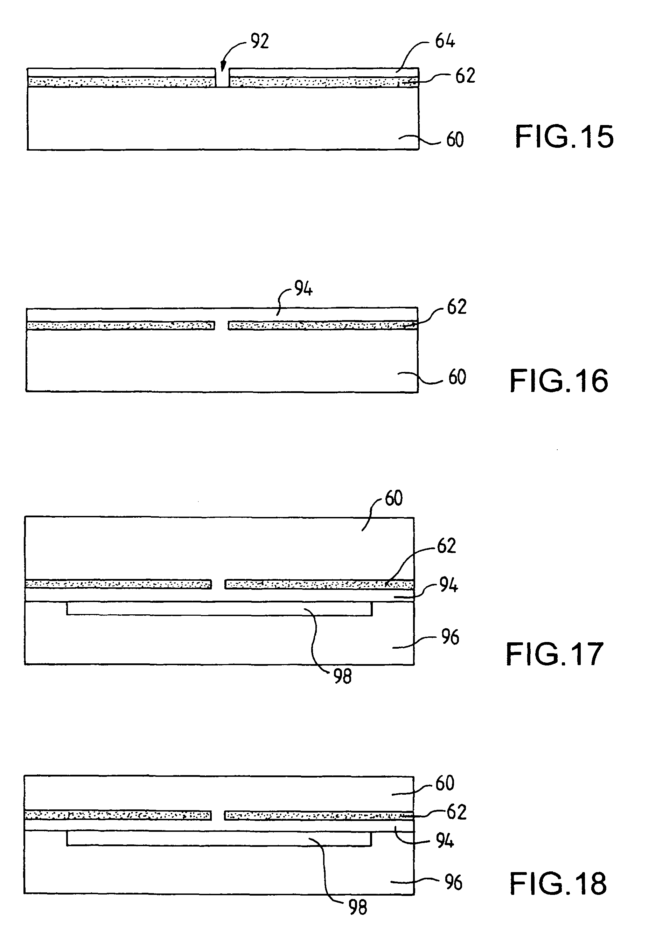

Dans une autre technique de fabrication représentée aux figures 15 à 18 on procède de la manière suivante :

On part d'un substrat semblable à celui de la figure 6 : substrat SOI composé d'une plaque de silicium 60 avec une couche d'oxyde de silicium enterrée 62 recouverte d'une couche de silicium 64. On ouvre une ouverture 92 dans ces deux couches à l'endroit qui doit constituer le pion central 14 de liaison entre la masse sismique et la membrane (figure 15).

On dépose une couche de silicium qui, d'une part, comble l'ouverture 92 en constituant le futur pion central de liaison entre la masse sismique et la membrane de support, et, d'autre part, augmente l'épaisseur de la couche 64 préexistante. La couche de silicium 94 ainsi constituée au-dessus de l'oxyde 62 constituera la membrane de support de la masse sismique (figure 16).

On retourne le substrat ainsi réalisé pour que la couche 94 soit maintenant au-dessous, et on colle ce substrat par sa face avant, c'est-à-dire par le côté de la couche 94, sur un autre substrat 96 qui possède une cavité superficielle 98 occupant toute la zone réservée à la membrane. Les substrats 60 et 96 ne sont donc collés qu'à leur périphérie et la couche de silicium 94 se trouve suspendue au-dessus de la cavité 98 (figure 17).

On amincit alors, par usinage mécanique et chimique, la face arrière du substrat 60 jusqu'à lui donner l'épaisseur qui est désirée pour la masse sismique, par exemple 50 micromètres ou moins (figure 18). L'épaisseur choisie est une épaisseur permettant une gravure facile et précise des armatures de peignes interdigités.

Les étapes suivantes sont les mêmes que celles qui ont été expliquées en référence aux figures 11 à 14 et ne seront pas décrites à nouveau : creusement du silicium pour définir les zones d'armatures plus basses ou plus hautes que les autres armatures ; formation des contacts électriques, gravure des peignes interdigités, et enfin dissolution de la couche d'oxyde de silicium 62 à travers les ouvertures ménagées par la gravure des peignes, pour libérer la membrane constituée par la couche de silicium 94.

**Revendications**

1. Structure d'accéléromètre micro-usinée **caractérisée en ce qu'**elle comporte un substrat (10), une membrane (12) élastiquement déformable en couche mince suspendue au-dessus du substrat et solidaire du substrat à sa périphérie, une masse sismique (M) suspendue au-dessus de la membrane et reliée à celle-ci par un pion central (14), et des peignes interdigités capacitifs (P1 à P8) répartis autour de la masse, ayant des armatures mobiles solidaires de la masse et des armatures fixes solidaires du substrat.

2. Structure d'accéléromètre selon la revendication 1, **caractérisée en ce que** les armatures fixes (AF1) de certains des peignes capacitifs ont une hauteur, mesurée dans le sens perpendiculaire à la membrane, plus faible que la hauteur des armatures mobiles (AM1) de ces peignes, et les armatures mobiles de certains peignes (AM3) ont une hauteur dans le sens perpendiculaire à la membrane plus faible que la hauteur des armatures fixes (AF3) de ces peignes.

3. Structure d'accéléromètre selon la revendication 2, **caractérisée en ce que**, sur chaque côté de la masse sismique, on prévoit deux peignes (P1, P2) ayant l'un des armatures fixes plus hautes que les armatures mobiles et l'autre des armatures mobiles plus hautes que les armatures fixes.

4. Structure d'accéléromètre selon la revendication 3, **caractérisé en ce que** les deux peignes (P1, P2) d'un même côté de la masse sismique ont des espacements entre armatures qui varient dans des sens opposés pour un même sens de déplacement horizontal de la masse sismique.

5. Structure d'accéléromètre selon la revendication 4, **caractérisée en ce que** deux peignes (P1, P3) en vis-à-vis sur deux côtés opposés ont l'un des armatures fixes plus hautes que les armatures mobiles et l'autre des armatures mobiles plus hautes que les armatures fixes.

6. Structure d'accéléromètre selon l'une des revendications 3 à 5, **caractérisée en ce que** deux peignes en vis-à-vis sur deux côtés opposés de la masse sismique ont des espacements entre armatures qui varient dans le même sens pour un même déplacement de la masse sismique parallèlement à ces côtés.

7. Structure d'accéléromètre selon l'une des revendications 1 à 6, **caractérisé en ce que** l'organisation des peignes capacitifs interdigités est symétrique pour que les capacités au repos en l'absence d'accélérations de tous les peignes interdigités soient identiques.

8. Structure d'accéléromètre selon l'une des revendications 1 à 7, **caractérisée en ce qu'**elle comporte des moyens pour effectuer une combinaison linéaire des valeurs de capacités de quatre peignes situés le long de ces côtés, la combinaison linéaire fournissant une mesure de l'accélération selon un axe horizontal parallèle à deux côtés de la masse sismique.

9. Structure d'accéléromètre selon l'une des revendications 1 à 7, **caractérisée en ce qu'**elle comporte des moyens pour effectuer une combinaison linéaire des valeurs de capacités de huit peignes, cette combinaison étant la différence entre la somme des capacités de quatre peignes (P1, P4, P6, P7) situés chacun sur un côté respectif de la masse sismique et ayant des armatures fixes plus basses que les armatures mobiles, et la somme des capacités de quatre autres peignes (P2, P3, P5, P8) situés également chacun sur un côté respectif de la masse sismique et ayant des armatures mobiles plus basses que les armatures fixes, la combinaison linéaire fournissant une mesure de l'accélération selon un axe vertical perpendiculaire à la membrane.

10. Structure d'accéléromètre selon l'une des revendications 1 à 9, **caractérisée en ce que** la masse sismique (M), les peignes interdigités (P1 à P8), la membrane (12) et le pion central (14) sont en silicium.

**Claims**

1. Micro machined accelerometer structure **characterised in that** it comprises a substrate (10), an elastically deformable thin layer membrane (12) suspended over the substrate and integral with the substrate on its periphery, a seismic mass (M) suspended over the membrane and connected thereto by a central pin (14) and interdigital comb capacitors (P1 to P8) distributed around the mass, having mobile armatures integral with the mass and fixed armatures integral with the substrate.

2. Accelerometer structure according to claim 1, **characterised in that** the height of the fixed armatures (AF1) of certain comb capacitors, measured perpendicular to the membrane, is lower than the height of the mobile armatures (AM1) on these combs, and the height of the mobile armatures of certain combs (AM3) perpendicular to the membrane is lower than the height of the fixed armatures (AF3) of these combs.

3. Accelerometer structure according to claim 2, **characterised in that**, on each side of the seismic mass, two combs (P1, P2) are provided having one of the fixed armatures higher than the mobile armatures and the other one of the mobile armatures higher than the fixed armatures.

4. Accelerometer structure according to claim 3, **characterised in that** the two combs (P1, P2) on the same side of the seismic mass have spacings between armatures which vary in the opposite directions for the same horizontal displacement direction of the seismic mass.

5. Accelerometer structure according to claim 4, **characterised in that** two combs (P1, P3), which are face-to-face on two opposite sides, have one of the fixed armatures higher than the mobile armatures and the other one of the mobile armatures higher than the fixed armatures.

6. Accelerometer structure according to one of claims 3 to 5, **characterised in that** two combs face-to-face on two opposite sides of the seismic mass have spacings between armatures which vary in the same direction for the same displacement of the seismic mass in parallel with these sides.

7. Accelerometer structure according to one of claims 1 to 6, **characterised in that** the organisation of the interdigital comb capacitors is symmetric so that, when idle and in the absence of accelerations, the capacitances of all interdigital combs are identical.

8. Accelerometer structure according to one of claims 1 to 7, **characterised in that** it comprises means for performing a linear combination of the capacitance values of four combs located along these sides, the linear combination providing an acceleration measurement according to a horizontal axis parallel to two sides of the seismic mass.

9. Accelerometer structure according to one of claims 1 to 7, **characterised in that** it comprises means for performing a linear combination of the capacitance values of eight combs, which combination is the difference between the sum of the capacitances of four combs (P1, P4, P6, P7) each located on a respective side of the seismic mass and having fixed armatures lower than the mobile armatures and the sum of the capacitances of four other combs (P2, P3, P5, P8) each also situated on a respective side of the seismic mass and having mobile armatures lower than the fixed armatures, the linear combination providing an acceleration measurement according to a vertical axis perpendicular to the membrane.

10. Accelerometer structure according to one of claims 1 to 9, **characterised in that** the seismic mass (M), the interdigital combs (P1 to P8), the membrane (12) and the central pin (14) are silicon.

**Patentansprüche**

1. Mikrobearbeitete Beschleunigungsmesserkonstruktion, **dadurch gekennzeichnet, dass** sie Folgendes umfasst: ein Substrat (10), eine Membran (12) aus einer dünnen Schicht, elastisch deformierbar, die über dem Substrat aufgehängt und an ihrer Peripherie einstückig mit dem Substrat ist, eine seismische Masse (M), die über der Membran aufgehängt und durch ein zentrales Pion (14) damit verbunden ist, und fingerartig verzahnte Kammkondensatoren (P1 bis P8), die um die Masse verteilt sind, mit mobilen Ankern einstückig mit dem Volumen und mit festen Ankern einstückig mit dem Substrat.

2. Beschleunigungsmesserkonstruktion nach Anspruch 1, **dadurch gekennzeichnet, dass** die Höhe der festen Anker (AF1) bestimmter Kammkondensatoren lotrecht zur Membran gemessen geringer ist als die Höhe der mobilen Anker (AM1) dieser Kämme und die Höhe der mobilen Anker bestimmter Kämme (AM3) lotrecht zur Membran geringer ist als die Höhe der festen Anker (AF3) dieser Kämme.

3. Beschleunigungsmesserkonstruktion nach Anspruch 2, **dadurch gekennzeichnet, dass** auf jeder Seite der seismischen Masse zwei Kämme (P1, P2) vorgesehen sind, wobei einer der festen Anker höher ist als die mobilen Anker und der andere der mobilen Anker höher ist als die festen Anker.

4. Beschleunigungsmesserkonstruktion nach Anspruch 3, **dadurch gekennzeichnet, dass** die zwei Kämme (P1, P2) auf derselben Seite der seismischen Masse Abstände zwischen Ankern haben, die in entgegengesetzten Richtungen für dieselbe horizontale Bewegungsrichtung der seismischen Masse variieren.

5. Beschleunigungsmesserkonstruktion nach Anspruch 4, **dadurch gekennzeichnet, dass** bei zwei Kämmen (P1, P3), die einander auf zwei gegenüberliegenden Seiten zugewandt sind, einer der festen Anker höher ist als die mobilen Anker und der andere der mobilen Anker höher als die festen Anker.

6. Beschleunigungsmesserkonstruktion nach einem der Ansprüche 3 bis 5, **dadurch gekennzeichnet, dass** zwei einander auf gegenüberliegenden Seiten der seismischen Masse zugewandte Kämme Abstände zwischen Ankern haben, die in derselben Richtung für dieselbe Bewegung der seismischen Masse parallel zu diesen Seiten variieren.

7. Beschleunigungsmesserkonstruktion nach einem der Ansprüche 1 bis 6, **dadurch gekennzeichnet, dass** die Organisation der fingerartig verzahnten Kammkondensatoren symmetrisch ist, so dass die Kapazitäten, im Ruhezustand in Abwesenheit von Beschleunigungen, in allen fingerartig verzahnten Kämmen identisch sind.

8. Beschleunigungsmesserkonstruktion nach einem der Ansprüche 1 bis 7, **dadurch gekennzeichnet, dass** sie Mittel zum Ausführen einer linearen Kombination der Kondensatorwerte von vier Kämmen umfasst, die sich auf diesen Seiten befinden, wobei die lineare Kombination einen Beschleunigungsmesswert gemäß einer horizontalen Achse parallel zu zwei Seiten der seismischen Masse geben.

9. Beschleunigungsmesserkonstruktion nach einem der Ansprüche 1 bis 7, **dadurch gekennzeichnet, dass** sie Mittel zum Ausführen einer linearen Kombination der Kapazitätswerte von acht Kämmen umfasst, wobei diese Kombination die Differenz zwischen der Summe der Kapazitäten von vier Kämmen (P1, P4, P6, P7), die sich jeweils auf einer jeweiligen Seite der seismischen Masse befinden und feste Anker haben, die niedriger sind als die mobilen Anker, und der Summe der Kapazitäten von vier anderen Kämmen (P2, P3, P5, P8) ist, die sich jeweils auf einer jeweiligen Seite der seismischen Masse befinden und mobile Anker haben, die niedriger sind als die festen Anker, wobei die lineare Kombination einen Beschleunigungsmesswert gemäß einer vertikalen Achse lotrecht zu der Membran ergibt.

10. Beschleunigungsmesserkonstruktion nach einem der Ansprüche 1 bis 9, **dadurch gekennzeichnet, dass** die seismische Masse (M), die fingerartig verzahnten Kämme (P1 bis P8), die Membran (12) und das zentrale Pion (14) aus Silicium sind.

FIG.1

FIG.2

13

P1                                                              P3

AF1        AM1              M              AM3    AF3                    z
                                                                        ↑        ⊗ y
                                                                        |
                                                                    o───────→ x

10

14        12

# FIG.3

AF1      AM1              M                AM3  AF3                      z
                                                                        ↑    ⊗
                                                                        |
                                                                    o───────→ x

10

14        12

# FIG.4

AM1              M                AM3    AF3                            z
                                                                        ↑        ⊗ y
                                                                        |
                                                                    o───────→ x

10

AF1              14        12

# FIG.5

FIG.6

FIG.7

FIG.8

FIG.9

FIG.10

FIG.11

FIG.12

FIG.13

FIG.14

FIG.15

FIG.16

FIG.17

FIG.18

## RÉFÉRENCES CITÉES DANS LA DESCRIPTION

**Littérature non-brevet citée dans la description**

- **MARK A. LEMKIN ; BERNHARD E. BOSER ; DAVID AUSLANDER ; JIM H. SMITH.** A 3-Axis Force Balanced Accelerometer Using a single Proof-Mass. *proceedings IEEE Transducers '97,* 1997